# EUROPEAN PATENT APPLICATION

(11) **EP 4 478 855 A1**
(43) Date of publication of application: **18.12.2024**
(21) Application number: 23752863.3
(22) Date of filing: 07.02.2023
(51) Int. Cl.: H05K 9/00, C01G 49/00, C04B 35/26, C08K 3/22, H01F 1/113

(54) **FERRITE PARTICLE POWDER FOR ELECTROMAGNETIC WAVE ABSORPTION, METHOD FOR MANUFACTURING SAME, AND RESIN COMPOSITION USING SAID FERRITE PARTICLE POWDER FOR ELECTROMAGNETIC WAVE ABSORPTION**

(30) Priority: 10.02.2022 JP 2022019980
(71) Applicant: Toda Kogyo Corp., Hiroshima 732-0828 (JP)
(72) Inventor: TSUKAMOTO, Hidemi, Otake-shi, Hiroshima 739-0652 (JP); WATANABE, Kozo, Otake-shi, Hiroshima 739-0652 (JP); MITSUI, Hideharu, Otake-shi, Hiroshima 739-0652 (JP); NISHIO, Yasushi, Otake-shi, Hiroshima 739-0652 (JP)
(74) Representative: Dennemeyer & Associates S.A.
(86) International application number: PCT/JP2023/003990
(87) International publication number: WO 2023/153399

(57) **Abstract**

Provided is a ferrite particle powder for electromagnetic wave absorption that can maintain flexibility and uniformity of physical properties of a sheet even when the sheet is highly filled with the ferrite particle powder and is excellent in electromagnetic wave absorbing performance in a GHz band. The ferrite particle powder is a ferrite particle powder for electromagnetic wave absorption, the ferrite particle powder containing magnetoplumbite-type ferrite represented by a chemical formula of AₓFe_{(12-y)}(Ti_{z}Mn_{(1-z)})_{y}O₁₉, where A is at least one selected from Ba, Sr, Ca, and Pb, x is 0.9 to 1.1, y is 5.0 or less, and z is 0.35 to 0.65, and the ferrite particle powder having: a compressed density of 3.00 g/cm³ or more; and an average particle diameter of 0.50 to 3.0 µm determined by an air permeability method (Blaine method).

## Description

### TECHNICAL FIELD

The present disclosure relates to a ferrite particle powder for electromagnetic wave absorption, a method for manufacturing the ferrite particle powder for electromagnetic wave absorption, and a resin composition using the ferrite particle powder for electromagnetic wave absorption.

### BACKGROUND ART

An electromagnetic wave absorbing sheet is required to have flexibility and electromagnetic wave absorbing performance. As means for improving the electromagnetic wave absorbing performance of the electromagnetic wave absorbing sheet using magnetoplumbite-type ferrite (hereinafter, may be abbreviated as M-type ferrite) having the electromagnetic wave absorbing performance in a GHz band, there are means for improving the absorption performance of the ferrite particle powder itself and means for highly filling the sheet with the ferrite particle powder. However, in general, as a filling amount is increased, the flexibility of the sheet is significantly reduced. Then, when the filling amount is excessively increased, sheeting itself is difficult.

Further, when the filling amount is increased, viscosity of the resin composition during melt-kneading increases. Therefore, it is difficult to finely disperse each component in the resin composition. As a result, the flexibility and uniformity of physical properties of the sheet are significantly reduced. In particular, an effect of an additive is exhibited by a trace amount of the additive. Therefore, there is a known problem that processability and physical properties of the sheet are greatly affected when microscopic fine dispersion of the additive is not achieved.

With advancement of information communication, 5G communication that has been spreading in recent years is expected to be used for many electronic devices. For this 5G communication, a radio wave having a frequency in the GHz band capable of transmitting large-capacity information at a high speed with a low delay and simultaneous connection is used. In addition, densification of electronic components has progressed along with miniaturization of the electronic devices. When a current flows through a densified electronic component, some energy may be radiated to another electronic component as an electromagnetic wave. Furthermore, the radiated electromagnetic wave may be reflected in a housing of the electronic device. As a result, these radiated or reflected electromagnetic waves may cause malfunction of the electronic device. In order to suppress an electromagnetic wave noise that causes such malfunction, an electromagnetic wave absorber is used.

The electromagnetic wave absorber is often used as a retrofit measure against a generation source of the electromagnetic wave noise. From this, the electromagnetic wave absorber to be used is attached not only to a flat surface but often also to a non-flat surface such as an electronic component. Therefore, the electromagnetic wave absorber is required to have good flexibility. At the same time, the electromagnetic wave absorber is often used at a place where there is almost no empty space in an electronic housing in which the electronic components are densely arranged. Therefore, the electromagnetic wave absorber is required to have a thin sheet shape and high electromagnetic wave absorbing performance.

An electromagnetic wave absorbing material is a material that converts absorbed electromagnetic wave energy into thermal energy. That is, an electromagnetic wave energy loss is the electromagnetic wave absorbing performance. For example, the electromagnetic wave energy is lost due to magnetic loss, dielectric loss, or conductive loss. M-type ferrite has high magnetocrystalline anisotropy. From this, the M-type ferrite exhibits magnetic resonance in the GHz band and indicates an imaginary part µ" of complex magnetic permeability for obtaining the magnetic loss at that frequency. Therefore, the M-type ferrite is promising as the electromagnetic wave absorbing material in a high frequency band.

For example, it is known that M-type barium ferrite has a resonance frequency around 50 GHz. However, due to its large coercive force, it is difficult to say that the M-type barium ferrite is soft magnetic. However, by substituting a part of iron with, for example, titanium, manganese, zinc, cobalt, nickel, copper, tin, or zirconium, soft magnetization proceeds. As a result, the magnetocrystalline anisotropy and saturation magnetization change. Therefore, the resonance frequency can be controlled to 50 GHz or less. In this way, it is possible to obtain electromagnetic wave absorbing ferrite capable of coping with various high frequency bands such as the 5G communication band.

The absorption performance of the electromagnetic wave absorber obtained by mixing the M-type ferrite and the resin greatly changes depending on the filling amount of ferrite in the resin. In order to improve the electromagnetic wave absorbing performance, it is necessary to increase the filling amount of ferrite. On the other hand, when the filling amount of ferrite is increased, the electromagnetic wave absorber required to have flexibility as the sheet will be a hard and brittle resin composition. That is, when the filling amount of ferrite is too large, sheet preparation itself is difficult.

Further, when the ferrite and the resin are kneaded, the resin is melted by heating. At this time, the resin composition having a high filling amount of ferrite has a high viscosity during melting. As a result, it is difficult for components in the resin composition to be uniformly mixed at the time of kneading, and thus fine dispersion is difficult. In particular, when the additive exhibiting the effect in a small amount is not finely dispersed microscopically, the effect of the additive is not sufficiently exhibited.

For example, when the sheet is prepared using a thermosetting resin acrylonitrile-butadiene rubber (NBR), the additive is added in addition to the resin and ferrite. Then, after these components are kneaded, appropriate elasticity and flexibility are imparted to the sheet by vulcanization. At this time, when the resin composition is highly filled with ferrite and thus has a high viscosity during melt-kneading, the additive is not finely dispersed microscopically. As a result, since subsequent vulcanization progresses ununiformly, the physical properties are deteriorated such that the sheet is hard and poor in flexibility.

Patent Literature 1 discloses an electromagnetic wave absorbing sheet having an electromagnetic wave absorbing layer containing magnetic iron oxide, which is an electromagnetic wave absorbing material that performs magnetic resonance in a frequency band of a millimeter wave band or more, and a rubber binder. A maximum elongation percentage of an elastic region in one direction in a plane of the electromagnetic wave absorbing sheet is 20% to 200%. A content rate of the magnetic iron oxide in the electromagnetic wave absorbing layer is 30 vol% or more. As the magnetic iron oxide, epsilon iron oxide or strontium ferrite is used.

Patent Literature 2 discloses a powder of Y-type hexagonal ferrite suitable for the electromagnetic wave absorber used in a high frequency band of 1 GHz or more. The powder of the Y-type hexagonal ferrite is represented by a composition formula of BaₓM_{y}Fe_{z}O₂₂ (1.5 ≤ x ≤ 2.2, 1.2 ≤ y ≤ 2.5, 11 ≤ z ≤ 13). Here, M is one or a combination of two or more of divalent metal elements (excluding Fe), or a combination of a monovalent metal element and a trivalent metal element (including a case of Fe). In a particle size distribution obtained by a laser diffraction particle size distribution measuring apparatus, a volume ratio of particles having a particle diameter of 1.0 µm or less among particles contained in the powder of the Y-type hexagonal ferrite is 10% or less. Further, the volume ratio of particles having a particle diameter of 10.2 µm or more is 12% or less.

Patent Literature 3 discloses a magnetoplumbite-type hexagonal ferrite which is represented by a composition formula of AFe_{(12-X)}(B1_{0.5}(Co_{(1-y)}Zn_{y})_{0.5})ₓO₁₉ and is suitable for the electromagnetic wave absorber for the GHz band. Here, A is one or two of Ba and Sr. B1 is one or two of Ti and Zr. x is 0.1 to 2.0. y is 0.2 to 0.8.

### CITATION LIST

### PATENT LITERATURE

Patent Literature 1: JP-A-2019-075571
Patent Literature 2: JP-A-2008-066364
Patent Literature 3: JP-A-2010-260766

### SUMMARY OF INVENTION

### PROBLEMS TO BE SOLVED BY INVENTION

The electromagnetic wave absorbing sheet is required to have flexibility and electromagnetic wave absorbing performance. In order to improve the absorption performance of the electromagnetic wave absorbing sheet using the M-type ferrite having electromagnetic wave absorbing performance in the GHz band, the sheet needs to be highly filled with ferrite powder. However, as the filling amount is increased, the flexibility of the sheet is significantly reduced. As a result, when the filling amount is excessively increased, the sheeting itself is difficult.

Further, when the filling amount is increased, viscosity of the resin composition during melt-kneading increases. Therefore, it is difficult to finely disperse each component in the resin composition. As a result, the flexibility or the uniformity of physical properties of the sheet is significantly reduced. In particular, an effect of an additive is exhibited by a trace amount of the additive. Therefore, there is a problem that processability and physical properties of the sheet are greatly affected when the additive is not finely dispersed microscopically.

Since an elongation percentage of an electromagnetic wave absorbing resin sheet containing magnetic iron oxide such as ferrite in the resin described in Patent Literature 1 is controlled, the electromagnetic wave absorbing resin sheet can also be installed in a portion where a shape of an installation place is not flat. However, this literature does not describe remedying, by powder control of magnetic iron oxide such as ferrite, a problem that when the resin composition highly filled with a filler is kneaded, microscopic fine dispersion of each component is deteriorated due to the high viscosity of the resin composition in a molten state, and thus sheet physical properties are also deteriorated.

The Y-type hexagonal ferrite suitable for the electromagnetic wave absorber used in a frequency band around 3 to 6 GHz described in Patent Literature 2 has a controlled particle diameter, so that a thickness of the electromagnetic wave absorbing sheet can be thinned. However, this literature does not describe remedying, by powder control of magnetic iron oxide such as ferrite, a problem that when the resin composition highly filled with a filler is kneaded, microscopic fine dispersion of each component is deteriorated due to the high viscosity of the resin composition in a molten state, and thus sheet physical properties are also deteriorated.

The magnetoplumbite-type hexagonal ferrite suitable for the electromagnetic wave absorber for the GHz band described in Patent Literature 3 can suppress frequency fluctuation due to thickness fluctuation of the electromagnetic wave absorbing resin sheet containing ferrite to be small. However, this literature does not describe remedying, by powder control of magnetic iron oxide such as ferrite, a problem that when the resin composition highly filled with a filler is kneaded, microscopic fine dispersion of each component is deteriorated due to the high viscosity of the resin composition in a molten state, and thus sheet physical properties are also deteriorated.

The present disclosure addresses the above problems. That is, an object of the present disclosure is to provide a ferrite powder for electromagnetic wave absorption that can maintain flexibility and uniformity of physical properties of a sheet even when the sheet is highly filled with the ferrite powder, and is excellent in electromagnetic wave absorbing performance in the GHz band, and a resin composition using the ferrite powder for electromagnetic wave absorption.

### SOLUTION TO PROBLEMS

As a result of intensive studies to solve the above problems, the researchers have found that the above problems are solved by optimizing powder characteristics to be focused of an M-type ferrite powder to predetermined characteristics.

That is, a first embodiment of the present disclosure is a ferrite particle powder for electromagnetic wave absorption, the ferrite particle powder containing magnetoplumbite-type ferrite represented by a chemical formula of AₓFe_{(12-y)}(Ti_{z}Mn_{(1-z)})_{y}O₁₉, where A is at least one selected from Ba, Sr, Ca, and Pb, x is 0.9 to 1.1, y is 5.0 or less, and z is 0.35 to 0.65, and the ferrite particle powder having: a compressed density of 3.00 g/cm³ or more; and an average particle diameter of 0.50 to 3.0 µm determined by an air permeability method (Blaine method).

A second embodiment of the present disclosure is the ferrite particle powder for electromagnetic wave absorption according to the first embodiment, the ferrite particle powder having a specific surface area of 0.50 to 4.0 m²/g.

A third embodiment of the present disclosure is a method for manufacturing the ferrite particle powder for electromagnetic wave absorption according to the first embodiment, the method including: mixing, molding, and firing an iron raw material, a titanium raw material, a manganese raw material, and a compound raw material of an element A to produce magnetoplumbite-type ferrite; pulverizing the magnetoplumbite-type ferrite; and then annealing the pulverized magnetoplumbite-type ferrite.

A fourth embodiment of the present disclosure is a resin composition containing the ferrite particle powder for electromagnetic wave absorption according to the first embodiment and a resin.

### EFFECTS OF INVENTION

According to electromagnetic wave absorbing M-type ferrite and the resin composition using the same according to the present embodiments, even a sheet highly filled with ferrite powder can maintain the flexibility and the uniformity of physical properties of the sheet. Further, the sheet is excellent in electromagnetic wave absorbing performance in the GHz band.

### BRIEF DESCRIPTION OF DRAWINGS

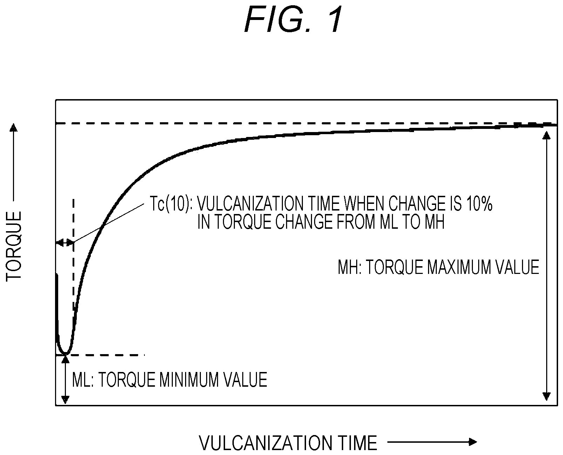

Fig. 1 is a conceptual diagram of a vulcanization curve created using a curelastometer.

### DESCRIPTION OF EMBODIMENTS

Hereinafter, the present embodiments will be described in detail. A ferrite particle powder for electromagnetic wave absorption according to the present embodiment contains magnetoplumbite-type ferrite represented by a chemical formula of AₓFe_{(12-y)}(Ti_{z}Mn_{(1-z)})_{y}O₁₉. Here, A is at least one element selected from Ba, Sr, Ca, and Pb. Preferred elements are Ba and Sr.

x is 0.9 to 1.1, preferably 0.94 to 1.06, and more preferably 0.97 to 1.03. y is 5.0 or less, preferably 0.02 to 4.20, more preferably 0.05 to 3.30, and still more preferably 0.08 to 2.40. z is 0.35 to 0.65, preferably 0.38 to 0.63, and more preferably 0.40 to 0.60. That is, the magnetoplumbite-type ferrite according to the present embodiment contains Ti and Mn in a ratio within a specific range.

When x is less than 0.9 or more than 1.1, it is difficult to obtain single-phase M-type ferrite. Therefore, x less than 0.9 or more than 1.1 is not preferable. When y exceeds 5.0, problems arise such as saturation magnetization being too low, and thus an imaginary part µ" of complex magnetic permeability for obtaining the magnetic loss also being low, a part of an additive element being not solid-solved in the ferrite and precipitated as an impurity, or pulverization efficiency decreasing due to significant curing of a sintered body during reaction firing. Therefore, y exceeding 5.0 is not preferable. When z is less than 0.35 or more than 0.65, electrical neutrality is not maintained, and as a result, the impurity is deposited. Therefore, z less than 0.35 or more than 0.65 is not preferable.

A compressed density of the ferrite particle powder for electromagnetic wave absorption according to the present embodiment is 3.00 g/cm³ or more. This makes it possible to reduce viscosity of a resin composition during melt-kneading. When the compressed density is less than 3.00 g/cm³, it is difficult to reduce the viscosity of the resin composition during melt-kneading. The compressed density is preferably 3.06 g/cm³ or more, and more preferably 3.10 g/cm³ or more. An upper limit of the compressed density is, for example, 3.60 g/cm³. The compressed density is measured by a method described in Examples described later.

An average particle diameter of the ferrite particle powder for electromagnetic wave absorption according to the present embodiment determined by an air permeability method (Blaine method) is 0.50 to 3.0 µm. When the average particle diameter is less than 0.50 µm, wettability between a surface of the ferrite powder and the resin is deteriorated. As a result, flexibility of a sheet is impaired. When the average particle diameter exceeds 3.0 µm, a resin space between ferrite powders increases, and thus the electromagnetic wave absorbing sheet is brittle. As a result, flexibility of a sheet is impaired. The average particle diameter is preferably 0.65 to 2.50 µm, and more preferably 0.80 to 2.00 µm.

The ferrite particle powder for electromagnetic wave absorption according to the present embodiment preferably has a specific surface area of 0.50 to 4.0 m²/g. When the specific surface area is less than 0.50, the resin space between the ferrite powders increases, and thus the electromagnetic wave absorbing sheet is brittle. As a result, flexibility of a sheet is impaired. When the specific surface area exceeds 4.0 m²/g, the wettability between the surface of the ferrite powder and the resin is deteriorated, and thus the flexibility of the sheet is impaired. The specific surface area is more preferably 1.00 to 3.80 m²/g, still more preferably 1.40 to 3.60 m²/g, and even more preferably 1.80 to 3.50 m²/g.

The ferrite particle powder for electromagnetic wave absorption according to the present embodiment preferably has a median diameter (D50) of 0.80 to 4.00 µm. When the median diameter (D50) is less than 0.80 µm, the wettability between the surface of the ferrite powder and the resin is deteriorated, and thus the flexibility of the sheet is impaired. When the median diameter (D50) exceeds 4.00 µm, the resin space between the ferrite powders increases, and thus the electromagnetic wave absorbing sheet is brittle. As a result, flexibility of a sheet is impaired. The median diameter (D50) is more preferably 1.00 to 3.60 µm, and still more preferably 1.20 to 3.10 µm.

Next, a method for manufacturing the ferrite particle powder for electromagnetic wave absorption according to the present embodiment will be described. In the method for manufacturing the ferrite particle powder for electromagnetic wave absorption according to the present embodiment, an iron raw material, a titanium raw material, a manganese raw material, and a compound raw material of an element A are mixed, molded, and fired to produce the magnetoplumbite-type ferrite. An intended ferrite particle powder for electromagnetic wave absorption is obtained by pulverizing the produced magnetoplumbite-type ferrite and then performing annealing treatment.

As the iron raw material, iron oxide such as α-Fe₂O₃ is preferably used. As the titanium raw material, titanium oxide such as TiO₂ is preferably used. As the manganese raw material, manganese oxide such as Mn₂O₃ or Mn₃O₄ is preferably used. Preferable examples of the raw material of the element A include oxides, hydroxides, and carbonates of Ba, Sr, Ca, and Pb.

First, the iron raw material, the titanium raw material, the manganese raw material, and the compound raw material of the element A weighed at a ratio corresponding to x, y, and z of the chemical formula: AₓFe_{(12-y)}(Ti_{z}Mn_{(1-z)})_{y}O₁₉ are mixed. These raw materials are mixed using, for example, a wet attritor, a homo-mixer, or a highspeed mixer. The obtained raw material mixture is pulverized and then granulated using an extrusion molding machine or the like.

During pulverization or granulation of the raw material mixture, a flux is preferably added. Preferred examples of the flux include BaCl₂·2H₂O, SrCl₂·6H₂O, CaCl₂·2H₂O, KCl, MgCl₂, NaCl, and Na₂B₄O₇. An addition amount of the flux is preferably 0.1 to 10.0 wt%, and more preferably 0.1 to 8.0 wt% with respect to the raw material mixture obtained as described above.

Further, Bi₂O₃ as a reaction accelerator may be added to and mixed with the raw material mixed powder or the pulverized powder after firing.

An obtained molded body is fired to produce the magnetoplumbite-type ferrite. A firing temperature is preferably 1000°C to1400°C, and more preferably 1050°C to 1350°C. When the firing temperature is lower than 1000°C, a fertilization reaction may not proceed sufficiently. Therefore, a single phase may not be obtained, or a theoretical saturation magnetization value (σs) in a corresponding composition may not be obtained. When the firing temperature is higher than 1400°C, fusion by sintering of particles proceeds, and thus a burden is imposed on a manufacturing process such as pulverization for controlling the particle diameter to a predetermined value. Therefore, the firing temperature higher than 1400°C is not preferable.

The obtained fired product is pulverized. The fired product may be pulverized at room temperature. Further, the fired product is pulverized using, for example, a hammer mill or a wet attritor. When the fired product is pulverized by the wet attritor, the pulverized product is then washed with water, filtered, and dried.

Next, the obtained pulverized product is annealed in the air, preferably at 600°C to 1100°C, and more preferably at 650°C to 1050°C. When an annealing temperature is higher than 1100°C, fusion by sintering of the particles proceeds, and thus it is difficult to obtain a powder having good dispersibility. Therefore, the annealing temperature higher than 1100°C is not preferable. Note that the annealing treatment is performed at a temperature lower than the firing temperature. In the present embodiment, the annealing treatment in this temperature range is important for achieving the powder characteristics of an M-type ferrite powder defined in the present embodiment.

Next, the resin composition and an electromagnetic wave absorbing material (electromagnetic wave absorbing sheet) used in the present embodiment will be described. The resin composition used in the present embodiment includes the ferrite particle powder for electromagnetic wave absorption and a resin. Examples of the resin include a hydrogenated styrene-based thermoplastic elastomer (SEBS), a vinyl chloride resin, an ethylene-vinyl acetate copolymer resin, an ethylene-ethyl acrylate copolymer resin, a PPS resin, a polyamide (nylon) resin, a polyamide elastomer, a polymerized fatty acid-based polyamide, an acrylonitrile butadiene rubber (NBR), a natural rubber (NR), an isoprene rubber (IR), an ethylene propylene rubber (EPDM), an acrylic rubber (ACM), and a silicone rubber (Q). Further, a mixing ratio of the ferrite particle powder for electromagnetic wave absorption is preferably 20 to 75 vol%.

In order to improve compatibility and dispersibility of a ferrite particle for electromagnetic wave absorption in the resin, the ferrite particle powder for electromagnetic wave absorption is preferably surface-treated in advance with a surface treatment agent. Examples of the surface treatment agent that can be added include a silane coupling agent and a titanate coupling agent. Furthermore, examples of the additive that can be added as necessary include a plasticizer, a reinforcing agent, a heat resistance improver, a thermally conductive filler, a pressure-sensitive adhesive, an antioxidant, a light stabilizer, an antistatic agent, and a colorant.

When various coupling agents are used, a coupling agent having, as functional groups, any one of a vinyl group, an epoxy group, an amino group, a methacrylic group, a mercapto group, a phosphoryl group, and a sulfo group and an alkoxy group such as a methoxy group or an ethoxy group can be used.

The ferrite particle powder for electromagnetic wave absorption (which may be surface-treated as necessary), the resin, and various additives as necessary are kneaded. Thereafter, the obtained kneaded product is molded and rolled into a desired thickness and shape by a known method. In this way, the electromagnetic wave absorbing sheet is manufactured.

When rubber is used as the resin, the resin may be vulcanized by the following method. First, the additives such as a vulcanizing agent (sulfur), a vulcanization accelerator (for example, 2-mercaptobenzothiazole (MBT) or N-cyclohexyl-2-benzothiazole sulfenamide (CBS)), or a vulcanization accelerator aid (for example, stearic acid or zinc oxide) are added to the resin composition. Then, components of the resin composition are kneaded, molded, and rolled at a temperature (for example, 60°C to 100°C) lower than a temperature at which a vulcanization reaction occurs to manufacture an unvulcanized sheet. Thereafter, the unvulcanized sheet is hot-pressed at a temperature (for example, 120°C to 200°C) at which the vulcanization reaction occurs. In this way, a vulcanized electromagnetic wave absorbing sheet is obtained.

The reason why the M-type ferrite particle powder according to the present embodiment is suitable as the ferrite particle powder for electromagnetic wave absorption is estimated as follows although it is not yet clear in detail. In order to improve the electromagnetic wave absorbing performance of the M-type ferrite powder itself, it is important that the theoretical saturation magnetization value (σs) in the corresponding composition is obtained, and elements constituting the corresponding composition are finely dispersed microscopically. In the present embodiment, by optimizing the method for manufacturing the ferrite, the M-type ferrite powder satisfying the above two points is obtained. This achieves high electromagnetic wave absorbing performance.

In addition, the compressed density is controlled to 3.0 g/cm³ or more. Furthermore, the average particle diameter is controlled to 0.5 to 3.0 µm. Thus, the viscosity of the resin composition during melt-kneading decreases, so that constituent elements of the resin composition can be finely dispersed microscopically. In addition, the ferrite powder has an excellent reinforcing effect on physical properties of the electromagnetic wave absorbing sheet. This makes it possible to obtain the electromagnetic wave absorbing sheet having excellent flexibility.

As the compressed density increases, the viscosity of the resin composition during melt-kneading can further decreases. Therefore, the additive can be finely dispersed microscopically. As a result, the effect can be exhibited by a trace amount of the additive. When the average particle diameter is less than 0.5 µm, the wettability between the surface of the ferrite powder and the resin is deteriorated. Therefore, the flexibility of the sheet is impaired. On the other hand, when the average particle diameter exceeds 3.0 µm, the resin space between the ferrite powders increases. This makes the electromagnetic wave absorbing sheet brittle. As a result, it is considered that the flexibility of the sheet is impaired.

### EXAMPLES

Representative embodiments of the present disclosure are as follows. First, a measurement method and an evaluation method will be described.

Amounts of elements (Ti, Mn, Zn, Ba, and Fe) contained in the ferrite particle powder were measured with an X-ray fluorescence spectrometer "ZSX Primus II" (manufactured by Rigaku Corporation). The obtained amounts of Ti, Mn, Zn, Ba, and Fe were converted into moles to calculate composition ratios x, y, and z.

As the compressed density (CD) of the ferrite particle powder, the density of the particle powder when compressed at a pressure of 1 t/cm² by a hydraulic press machine was adopted.

The average particle diameter of the ferrite particle powder determined by the air permeability method (Blaine method) (Ps-b) was measured by a "constant-pressure ventilation type rapid standard universal powder specific surface area measuring apparatus" (manufactured by Shimadzu Corporation).

The specific surface area (SSA) of the ferrite particle powder was measured by the principle of the BET one-point method using a nitrogen gas adsorption/desorption characteristic with respect to a sample using a "specific surface area analyzer Macsorb" (manufactured by Mountech Co., Ltd.).

The median diameter (D50) of the ferrite particle powder was measured by a "laser diffraction particle size distribution analyzer HELOS & RODOS (measurement unit type HELOS/BF-M, airflow type dry dispersion unit RODOS/M)" (manufactured by Sympatec GmbH) by the HELOS/BF-M in a measurement range 1 (0.1/0.18 to 35 µm) using a sample dispersed at a dispersion pressure of 5 bar in the RODOS/M.

As radio wave absorption characteristics of the electromagnetic wave absorbing sheet prepared using the ferrite particle powder, an absorption peak frequency and a transmission attenuation amount (S₂₁) were measured using a "network analyzer E8361A" (manufactured by Agilent Technologies).

A tensile elastic modulus was measured according to JIS K6251 standard by the following method. First, a lump rubber composition was prepared using "Labo Plastomill 4C150" (manufactured by Toyo Seiki Seisaku-sho, Ltd.). Thereafter, an unvulcanized rubber sheet was prepared using a "tabletop test mixing roll 191-TM" (manufactured by YASUDA SEIKI SEISAKUSHO, LTD.). Subsequently, a vulcanized rubber sheet was prepared using a "hot press machine" (manufactured by TESTER SANGYO CO., LTD.). Further, a dumbbell test piece (total length 115 mm, width 25.0 mm, thickness 2.0 mm ± 0.2 mm) was obtained using a test piece punching blade No. 5. Thereafter, the tensile elastic modulus was measured using a "computer-measured and controlled precision universal tester AG-1" (manufactured by Shimadzu Corporation).

A vulcanization test was performed in accordance with JIS K6300-2 standard (Die vulcanization test method A) using a curelastometer, so that a vulcanization curve can be obtained. The lump rubber composition was prepared for the vulcanization test using "Labo Plastomill 4C150" (manufactured by Toyo Seiki Seisaku-sho, Ltd.). Thereafter, the unvulcanized rubber sheet (thickness 3.2 ± 0.2 mm) was prepared using the "tabletop test mixing roll 191-TM" (manufactured by YASUDA SEIKI SEISAKUSHO, LTD.). A circular resin sheet having a diameter of 45 mm was punched out from the sheet. Thereafter, the vulcanization curve was obtained using "Curelastometer 7" (manufactured by JSR trading Co., Ltd.). In this measurement method, the resin sheet punched into a circular shape is vulcanized by applying a torsional torque while being heated. A vulcanization property is obtained from a curve representing a torque change from before the start of vulcanization to the end of vulcanization.

Fig. 1 is a conceptual diagram of the vulcanization curve created using the curelastometer. From the vulcanization curve, information on sheet physical properties of the resin including a minimum value ML of torque before vulcanization and a maximum value MH of torque after vulcanization is obtained. Furthermore, information on a speed of vulcanization, such as a 10% vulcanization time Tc(10) (time from the start of vulcanization to completion of 10% change in torque change from ML to MH), is also obtained.

The maximum value MH of torque after vulcanization is an index indicating how much elasticity the sheet after vulcanization has. A higher value indicates that the sheet is harder. A lower value indicates that the sheet is softer.

Further, the 10% vulcanization time Tc(10) is a time required for initial vulcanization. The smaller this value, the faster the vulcanization proceeds. Considering a sheet state when vulcanization proceeds quickly, when the time required for initial vulcanization is short (Tc(10) is small), it is difficult to say that fine dispersion of components such as additives has been sufficiently achieved. As a result, it is expected that uneven vulcanization has occurred. In addition, when the initial vulcanization gradually progresses (Tc(10) is large), it is considered that uniform vulcanization has occurred.

### Examples 1 to 7

### <Manufacturing of ferrite particle powder>

Various powder raw materials (α-Fe₂O₃, TiO₂, Mn₃O₄, BaCO₃) weighed so that compositions of final treated products had composition formulas shown in Table 1 were mixed for 15 minutes by the wet attritor. The resulting mixture was then filtered and dried. BaCl₂·2H₂O was added to the obtained raw material mixed powder, and the resulting mixture was well mixed. The resulting mixture was then extruded. At this time, an addition amount of BaCl₂·2H₂O was 3.0 wt% with respect to the raw material mixed powder. The obtained granulated product was fired at 1280°C in the air. The obtained fired product was coarsely pulverized, and subsequently pulverized by the wet attritor. The obtained pulverized product was washed with water, filtered, and dried. Subsequently, the obtained pulverized product was annealed at 600°C in the air. Manufacturing conditions at this time are shown in Table 1, and various properties of the obtained ferrite particle powders are shown in Table 2.

### Comparative Example 1

The ferrite particle powder was manufactured by the same method as in Example 3 except that the annealing treatment was not performed. Manufacturing conditions at this time are shown in Table 1, and various properties of the obtained ferrite particle powders are shown in Table 2.

### Comparative Example 2

The ferrite particle powder was manufactured by the same method as in Example 1 except that composition of the ferrite particle powder was changed (Zn was added) and the annealing treatment was not performed. Manufacturing conditions at this time are shown in Table 1, and various properties of the obtained ferrite particle powders are shown in Table 2.

**[Table 1]**

| | Composition | | Manufacturing conditions offerrite particle powder | | | |
|---|---|---|---|---|---|---|
| | Substitution amount y | Composition formula | BaCl₂ | Na₂B₄O₇ | Firing temperature | Annealing temperature |
| | | | (wt%) | (wt%) | (°C) | (°C) |
| Example 1 | 1.5 | Ba_{1.0}Fe_{10.5}(Ti_{0.5}Mn_{0.5})_{1.5}O₁₉ | 3 | 0 | 1280 | 600 |
| Example 2 | 1.5 | Ba_{1.0}Fe_{10.5}(Ti_{0.5}Mn_{0.5})_{1.5}O₁₉ | 3 | 0.6 | 1280 | 700 |
| Example 3 | 1.6 | Ba_{1.0}Fe_{10.6}(Ti_{0.5}Mn_{0.5})_{1.6}O₁₉ | 3 | 0 | 1150 | 600 |
| Example 4 | 2.4 | Ba_{1.0}Fe_{9.6}(Ti_{0.5}Mn_{0.5})_{2.4}O₁₉ | 2 | 0 | 1280 | 600 |
| Example 5 | 1.8 | Ba_{1.0}Fe_{10.2}(Ti_{0.5}Mn_{0.5})_{1.8}0₁₉ | 4 | 0 | 1290 | 600 |
| Example 6 | 1.1 | Ba_{1.0}Fe_{10.9}(Ti_{0.5}Mn_{0.5})_{1.1}O₁₉ | 4 | 0 | 1280 | 900 |
| Example 7 | 0.1 | Ba₁₀Fe_{11.9}(Ti_{0.4}Mn_{0.6})_{0.1}O₁₉ | 4 | 0.3 | 1280 | 600 |
| Comparative Example 1 | 1.5 | Ba_{1.0}Fe_{10.5}(Ti_{0.5}Mn_{0.5})_{1.5}O₁₉ | 3 | 0 | 1150 | - |
| Comparative Example 2 | 1.5 | Ba_{1.0}Fe_{10.5}(Ti_{0.5}(Mn_{0.5}Zn_{0.5})_{0.5})_{1.5}O₁₉ | 3 | 0 | 1280 | - |

**[Table 2]**

| | Powder characteristics offerrite particle powder | | | | |
|---|---|---|---|---|---|
| | Substitution amounty | Ps-b | D50 | CD | SSA |
| | | (um) | (um) | (g/cm³) | (m²/g) |
| Example 1 | 1.5 | 1.13 | 1.62 | 3.24 | 2.91 |
| Example 2 | 1.5 | 1.88 | 3.14 | 3.37 | 1.60 |
| Example 3 | 1.6 | 0.81 | 1.22 | 3.02 | 3.44 |
| Example 4 | 2.4 | 1.36 | 2.28 | 3.24 | 2.38 |
| Example 5 | 1.8 | 1.27 | 1.82 | 3.10 | 2.18 |
| Example 6 | 1.1 | 1.30 | 1.64 | 3.23 | 1.82 |
| Example 7 | 0.1 | 1.35 | 1.93 | 3.25 | 2.18 |
| Comparative Example 1 | 1.5 | 0.95 | 1.78 | 2.75 | 2.55 |
| Comparative Example 2 | 1.5 | 1.46 | 2.51 | 2.86 | 1.83 |

### Examples 8 to 13

### <Preparation of electromagnetic wave absorbing sheet>

60.0 vol% of each ferrite particle powder obtained in Examples 1 to 6, 39.0 vol% of a hydrogenated styrene-based thermoplastic elastomer (SEBS) resin, and 1.0 vol% of a titanate coupling agent (PLENACT TTS manufactured by Ajinomoto Fine-Techno Co., Inc.) were roll-kneaded at 160°C. Thereafter, the obtained kneaded product was molded and rolled to prepare the electromagnetic wave absorbing sheet. In the course of molding and rolling, a thickness of the electromagnetic wave absorbing sheet to be prepared was adjusted to 1 mm.

### <Measurement of electromagnetic wave absorbing sheet>

The absorption peak frequency and the transmission attenuation amount (S₂₁) of the obtained electromagnetic wave absorbing sheet were measured using the "network analyzer E8361A" (manufactured by Agilent Technologies). The radio wave absorption characteristics at this time are shown in Table 3.

**[Table 3]**

| | Ferrite particle powder used | Radio wave absorption characteristics | |
|---|---|---|---|
| | | Peak frequency | Transmission attenuation amount |
| | | (GHz) | (dB) |
| Example 8 | Example 1 | 30.6 | -9.1 |
| Example 9 | Example 2 | 31.0 | -9.5 |
| Example 10 | Example 3 | 29.9 | -8.3 |
| Example 11 | Example 4 | 24.3 | -7.8 |
| Example 12 | Example 5 | 28.3 | -7.9 |
| Example 13 | Example 6 | 34.9 | -9.5 |
| Comparative Example 3 | Comparative Example 1 | 28.9 | -7.6 |
| Comparative Example 4 | Comparative Example 2 | 29.1 | -8.3 |

### Comparative Examples 3 and 4

60.0 vol% of each ferrite particle powder obtained in Comparative Examples 1 and 2, 39.0 vol% of the hydrogenated styrene-based thermoplastic elastomer (SEBS) resin, and 1.0 vol% of the titanate coupling agent (PLENACT TTS manufactured by Ajinomoto Fine-Techno Co., Inc.) were roll-kneaded at 160°C. However, a lump resin kneaded product was obtained during kneading. Then, a phenomenon occurred in which the kneaded product was not caught in a molding roll. Therefore, preparation of the electromagnetic wave absorbing sheet using the SEBS resin was abandoned. Therefore, a sheet was prepared using NBR as an alternative resin.

60.0 vol% of each ferrite particle powder obtained in Comparative Examples 1 and 2, 35.0 vol% of NBR (N239SV manufactured by JSR Corporation), and 0.69 vol% of stearic acid, 0.26 vol% of zinc oxide, 0.25 vol% of sulfur, 0.55 vol% of N-cyclohexyl-2-benzothiazole sulfenamide (CBS), and 3.3 vol% of Polysizer W320 (manufactured by DIC Corporation) as additives such as the vulcanizing agent and the vulcanization accelerator were kneaded at 80°C. Thereafter, the obtained kneaded product was molded and rolled to prepare the unvulcanized sheet. In the course of molding and rolling, the thickness of the unvulcanized sheet to be prepared was adjusted to 1.0 mm. Subsequently, the unvulcanized sheet was heated at 150°C using a hot press. Thereafter, a pressure of 3 MPa was applied for 10 minutes to prepare a vulcanized electromagnetic wave absorbing sheet. Electromagnetic wave absorption measurement of the obtained electromagnetic wave absorbing sheet was performed in the same manner as in Examples 8 to 13.

### Examples 14 to 16 and Comparative Examples 5 and 6

### <Preparation of dumbbell test piece for tensile test of resin composition>

60.0 vol% of each ferrite particle powder obtained in Examples 1, 3, and 5 and Comparative Examples 1 and 2, 35.0 vol% of NBR (N239SV manufactured by JSR Corporation), and 0.69 vol% of stearic acid, 0.26 vol% of zinc oxide, 0.25 vol% of sulfur, 0.55 vol% of N-cyclohexyl-2-benzothiazole sulfenamide (CBS), and 3.3 vol% of Polysizer W320 (manufactured by DIC Corporation) as additives such as the vulcanizing agent and the vulcanization accelerator were kneaded at 80°C. Thereafter, the obtained kneaded product was molded and rolled at 60°C to prepare an unvulcanized sheet. In the course of molding and rolling, the thickness of the unvulcanized sheet was adjusted to 2.0 mm. Subsequently, the unvulcanized sheet was heated at 180°C for 25 minutes by hot pressing. Thereafter, the pressure of 3 MPa was applied for 5 minutes to prepare a vulcanized electromagnetic wave absorbing sheet. Thereafter, the dumbbell test piece was punched out from the sheet using a test piece punching blade No. 5. The tensile elastic modulus of a test piece molded body is shown in Table 4.

### <Preparation of test piece for vulcanization curve measurement of resin composition>

60.0 vol% of each ferrite particle powder obtained in Examples 1, 3, and 5 and Comparative Examples 1 and 2, 35.0 vol% of NBR (N239SV manufactured by JSR Corporation), and 0.69 vol% of stearic acid, 0.26 vol% of zinc oxide, 0.25 vol% of sulfur, 0.55 vol% of N-cyclohexyl-2-benzothiazole sulfenamide (CBS), and 3.3 vol% of Polysizer W320 (manufactured by DIC Corporation) as additives such as the vulcanizing agent and the vulcanization accelerator were kneaded at 80°C. Thereafter, the obtained kneaded product was molded and rolled to a thickness of 3.2 mm with a roll at 60°C to prepare an unvulcanized sheet. In the course of molding and rolling, the thickness of the unvulcanized sheet to be obtained was adjusted to 3.2 mm. Subsequently, a circular test piece was punched out from the sheet using a circular punching blade (diameter: 45 mm).

The maximum value MH of torque obtained from the vulcanization curve at 180°C of the test piece molded body and the 10% vulcanization time Tc(10) are shown in Table 4.

**[Table 4]**

| | Ferrite particle powder used | Sheet evaluation | | |
|---|---|---|---|---|
| | | Tensile elastic modulus | MH | Tc(10) |
| | | (MPa) | (kgf·cm) | (min.) |
| Example 14 | Example 1 | 21.5 | 15.6 | 1.0 |
| Example 15 | Example 3 | 29.0 | 18.6 | 1.1 |
| Example 16 | Example 5 | 33.4 | 15.4 | 1.1 |
| Comparative Example 5 | Comparative Example 1 | 62.1 | 25.3 | 0.5 |
| Comparative Example 6 | Comparative Example 2 | 40.4 | 22.5 | 0.7 |

As is apparent from Table 4, tensile elastic moduli of Examples 14, 15, and 16 were low values of 21 to 34 MPa. On the other hand, Comparative Examples 5 and 6 showed high values of 40 to 63 MPa. From this, it is apparent that when the ferrite of Examples is used, a sheet which is easy to stretch and soft can be prepared.

Next, MHs of Examples 14, 15, and 16 were low values of 15 to 19 kgfm. In contrast, Comparative Examples 5 and 6 showed high values of 22 to 26 kgf·m. From this, it is apparent that when the ferrite of Examples is used, a soft sheet can be prepared.

Further, Tc(10) of Examples 14, 15, and 16 was confirmed to be 1 minute or more. In contrast, Tc (10) of Comparative Examples 5 and 6 was confirmed to be a short time of 0.7 minutes or less. From this, uniform vulcanization is achieved in the ferrite of Examples. That is, it is considered that components contained in the resin composition are finely dispersed because the viscosity of the resin composition during melt-kneading is low.

### INDUSTRIAL APPLICABILITY

The ferrite particle powder for electromagnetic wave absorption according to the present embodiment can maintain flexibility and uniformity of physical properties of the sheet even when the sheet is highly filled with the ferrite particle powder and is excellent in electromagnetic wave absorbing performance in a GHz band. Therefore, the ferrite particle powder for electromagnetic wave absorption according to the present embodiment can be suitably used for the electromagnetic wave absorbing material.

## Claims

1. A ferrite particle powder for electromagnetic wave absorption, the ferrite particle powder comprising magnetoplumbite-type ferrite represented by a chemical formula of AₓFe_{(12-y)}(Ti_{z}Mn_{(1-z)})_{y}O₁₉, where A is at least one selected from Ba, Sr, Ca, and Pb, x is 0.9 to 1.1, y is 5.0 or less, and z is 0.35 to 0.65, and the ferrite particle powder having:
a compressed density of 3.00 g/cm³ or more; and
an average particle diameter of 0.50 to 3.0 µm determined by an air permeability method (Blaine method).

2. The ferrite particle powder for electromagnetic wave absorption according to claim 1, the ferrite particle powder having a specific surface area of 0.50 to 4.0 m²/g.

3. A method for manufacturing the ferrite particle powder for electromagnetic wave absorption according to claim 1, the method comprising:
mixing, molding, and firing an iron raw material, a titanium raw material, a manganese raw material, and a compound raw material of an element A to produce magnetoplumbite-type ferrite;
pulverizing the magnetoplumbite-type ferrite; and
annealing the pulverized magnetoplumbite-type ferrite.

4. A resin composition comprising the ferrite particle powder for electromagnetic wave absorption according to claim 1 or 2 and a resin.
